# EUROPEAN PATENT APPLICATION

(11) **EP 3 940 799 A1**
(43) Date of publication of application: **19.01.2022**
(21) Application number: 20774022.6
(22) Date of filing: 13.03.2020
(51) Int. Cl.: H01L 35/32, H02N 11/00

(54) **THERMOELECTRIC CONVERSION MODULE**

(30) Priority: 15.03.2019 JP 2019048660
(71) Applicant: Mitsubishi Materials Corporation, Tokyo 100-8117 (JP)
(72) Inventor: ARAI, Koya, Saitama-shi, Saitama 330-8508 (JP); MORI, Tomohiro, Saitama-shi, Saitama 330-8508 (JP); DOI, Hideo, Saitama-shi, Saitama 330-8508 (JP); KAMIJYO, Hiroki, Saitama-shi, Saitama 330-8508 (JP); NAGATOMO, Yoshiyuki, Saitama-shi, Saitama 330-8508 (JP)
(74) Representative: Hoffmann Eitle
(86) International application number: PCT/JP2020/011034
(87) International publication number: WO 2020/189543

(57) **Abstract**

This thermoelectric conversion module (10) includes: a plurality of thermoelectric conversion elements (11); a first electrode part (21) disposed to one end of each of the thermoelectric conversion elements (11); and a second electrode part (22) disposed to the other end of each of the thermoelectric conversion elements, in which the plurality of thermoelectric conversion elements (11) are electrically connected to each other via the first electrode part (21) and the second electrode part (22), the thermoelectric conversion elements (11) are sealed by a sealing layer (15) formed of an insulating inorganic material, and one surfaces of the first electrode part (21) and the second electrode part (22) are exposed from the sealing layer (15).

## Description

### TECHNICAL FIELD

The present invention relates to a thermoelectric conversion module in which a plurality of thermoelectric conversion elements are electrically connected to each other.

Priority is claimed on Japanese Patent Application No. 2019-048660, filed March 15, 2019, the content of which is incorporated herein by reference.

### BACKGROUND ART

A thermoelectric conversion element is an electronic element that enables conversion between thermal energy and electric energy by the Seebeck effect or the Peltier effect.

The Seebeck effect is a phenomenon in which an electromotive force is generated when a temperature difference is generated between both ends of a thermoelectric conversion element, and thermal energy is converted into electric energy. The electromotive force generated by the Seebeck effect is determined by the characteristics of the thermoelectric conversion element. In recent years, thermoelectric power generation utilizing this effect has been actively developed.

The Peltier effect is a phenomenon in which a temperature difference is generated at both ends of a thermoelectric conversion element when an electrode or the like is formed at both ends of the thermoelectric conversion element and a potential difference is generated between the electrodes, and electric energy is converted into thermal energy. An element having this effect is particularly called a Peltier element, and is used for cooling and temperature control of precision instruments and small refrigerators.

As a thermoelectric conversion module using the above-described thermoelectric conversion element, for example, a structure in which n-type thermoelectric conversion elements and p-type thermoelectric conversion elements are alternately connected in series has been proposed.

Such a thermoelectric conversion module has a structure in which by electrode parts disposed to one end and the other end of a plurality of thermoelectric conversion elements, the thermoelectric conversion elements are connected in series.

By generating a temperature difference between one end side and the other end side of the thermoelectric conversion element, electric energy can be generated by the Seebeck effect. Alternatively, by passing an electric current through the thermoelectric conversion element, it is possible to generate a temperature difference between one end side and the other end side of the thermoelectric conversion element due to the Peltier effect.

In a case where the above-mentioned thermoelectric conversion module is disposed in a heat source to obtain electric energy, the state of thermal contact with the heat source is important.

For example, Patent Document 1 discloses that a heat transfer sheet made of graphite is disposed between a heat source and a thermoelectric conversion module.

Patent Document 2 discloses that a heat transfer member made of metal is disposed between a heat source and a thermoelectric conversion module.

In the above-mentioned thermoelectric conversion modules, it is necessary to secure weather resistance in order to suppress the degradation of a thermoelectric conversion element during use.

For example, Patent Document 3 discloses a thermoelectric conversion module in which a waterproof frame having heat resistance is disposed in order to improve weather resistance.

Patent Document 4 discloses a thermoelectric conversion module in which a sealing material such as rubber is disposed in order to suppress the intrusion of moisture.

### [Citation List]

### [Patent Documents]

[Patent Document 1] Japanese Unexamined Patent Application, First Publication No. 2018-074873
[Patent Document 2] Japanese Unexamined Patent Application, First Publication No. 2014-127617
[Patent Document 3] Japanese Unexamined Patent Application, First Publication No. 2007-221895
[Patent Literature 4] Japanese Unexamined Patent Application, First Publication No. 2003-324219

### SUMMARY OF INVENTION

### Technical Problem

By disposing the above-mentioned thermoelectric conversion module in a heat source having a wide temperature range, heat exhausted from the heat source can be converted into electric energy.

For example, in a case where the thermoelectric conversion module is used in a high temperature region of 250°C or higher, an organic sealing material such as rubber or resin cannot be used because the organic sealing material is thermally decomposed or deteriorated and thus degraded. In addition, graphite cannot also be used stably because graphite is degraded by oxidation in the air.

A metal having a high melting point can be used. However, in a case where a member made of metal is disposed, the number of components increases, and there is concern that stable use may not be possible due to misalignment, coming-off, or the like. Furthermore, in a case where a waterproof frame or the like is used, it is difficult to dispose the waterproof frame in a narrow space or a rotating body or the like because the size thereof is large and an increase in the weight is incurred.

This invention has been made in view of the above-described circumstances, and an object thereof is to provide a thermoelectric conversion module in which excellent weather resistance is achieved, the degradation of thermoelectric conversion elements in a use environment is suppressed, and favorable and stable use is possible even at a high temperature, with a relatively simple structure.

### Solution to Problem

In order to solve the above problems, a thermoelectric conversion module according to an aspect of the present invention includes: a plurality of thermoelectric conversion elements; a first electrode part disposed to one end of each of the thermoelectric conversion elements; and a second electrode part disposed to the other end of each of the thermoelectric conversion elements, in which the plurality of thermoelectric conversion elements are electrically connected to each other via the first electrode part and the second electrode part, the thermoelectric conversion elements are sealed by a sealing layer formed of an insulating inorganic material, and one surfaces of the first electrode part and the second electrode part are exposed from the sealing layer.

According to the thermoelectric conversion module according to the aspect of the present invention, since the thermoelectric conversion elements are sealed by the sealing layer formed of the insulating inorganic material, even in a case where the thermoelectric conversion module is used in a high temperature region of 250°C or higher, the sealing layer is not altered, and excellent weather resistance is achieved, so that the degradation of the thermoelectric conversion element can be suppressed. In addition, since the thermoelectric conversion elements are protected by the sealing layer formed of the insulating inorganic material, the structure is simple, and a reduction in the size and weight of the thermoelectric conversion module can be achieved.

Furthermore, since one surfaces of the first electrode part and the second electrode part are exposed from the sealing layer, the electric energy generated in the thermoelectric conversion elements can be efficiently extracted via the first electrode part and the second electrode part.

In the thermoelectric conversion module according to the aspect of the present invention, it is preferable that the inorganic material forming the sealing layer has a thermal conductivity of 2 W/(m·K) or less at 25°C.

In this case, heat transfer via the sealing layer can be suppressed, it is possible to sufficiently secure a temperature difference between one end and the other end of the thermoelectric conversion elements, and the thermoelectric conversion efficiency can be improved.

The thermoelectric conversion module according to the aspect of the present invention may have a configuration in which a first insulating circuit board including a first insulating layer and a first circuit layer formed on one surface of the first insulating layer is disposed to one end of each of the thermoelectric conversion elements, and the first circuit layer is disposed so as to cover the first electrode part exposed from the sealing layer.

In this case, the contact between the first electrode part and the first circuit layer is improved, and the insulating properties are secured by the first insulating layer, so that it is possible to sufficiently improve the thermoelectric conversion efficiency. In addition, as described above, by disposing the first insulating circuit board, the insulating properties and the heat transfer properties can be secured, and a reduction in the number of components can be achieved.

In the thermoelectric conversion module according to the aspect of the present invention, it is preferable that a contact area of the first circuit layer is equal to or larger than an exposed area of the first electrode part.

In this case, since the contact area of the first circuit layer disposed so as to cover the first electrode part exposed from the sealing layer is equal to or larger than the exposed area of the first electrode part, infiltration of moisture or the like from the interface between the first electrode part and the sealing layer can be suppressed, and it is possible to more reliably suppress the degradation of the thermoelectric conversion elements.

The thermoelectric conversion module according to the aspect of the present invention may have a configuration in which a second insulating circuit board including a second insulating layer and a second circuit layer formed on one surface of the second insulating layer is disposed to the other end of each of the thermoelectric conversion elements, and the second circuit layer is disposed so as to cover the second electrode part exposed from the sealing layer.

In this case, the contact between the second electrode part and the second circuit layer is improved, and the insulating properties are secured by the second insulating layer, so that it is possible to sufficiently improve the thermoelectric conversion efficiency. In addition, as described above, by disposing the second insulating circuit board, the insulating properties and the heat transfer properties can be secured, and a reduction in the number of components can be achieved.

In the thermoelectric conversion module according to the aspect of the present invention, it is preferable that a contact area of the second circuit layer is equal to or larger than an exposed area of the second electrode part.

In this case, since the contact area of the second circuit layer disposed so as to cover the second electrode part exposed from the sealing layer is equal to or larger than the exposed area of the second electrode part, infiltration of moisture or the like from the interface between the second electrode part and the sealing layer can be suppressed, and it is possible to more reliably suppress the degradation of the thermoelectric conversion elements.

### Advantageous Effects of Invention

According to the present invention, it is possible to provide a thermoelectric conversion module in which excellent weather resistance is achieved, the degradation of thermoelectric conversion elements in a use environment is suppressed, and favorable and stable use is possible even at a high temperature, with a relatively simple structure.

### BRIEF DESCRIPTION OF DRAWINGS

Fig. 1 is a schematic explanatory view of a thermoelectric conversion module according to an embodiment of the present invention.
Fig. 2 is a cross-sectional view taken along the line A-A shown in Fig. 1.
Fig. 3 is a cross-sectional view taken along the line B-B shown in Fig. 1.
Fig. 4 is a flowchart showing a method for producing a thermoelectric conversion module according to the embodiment of the present invention.
Fig. 5 is a schematic explanatory view of a thermoelectric conversion module according to another embodiment of the present invention.
Fig. 6 is a schematic explanatory view of a thermoelectric conversion module according to another embodiment of the present invention.

### DESCRIPTION OF EMBODIMENTS

Hereinafter, embodiments of the present invention will be described with reference to the accompanying drawings. Each embodiment to be described below is specifically described for better understanding of the gist of the invention, and does not limit the present invention unless otherwise specified. In addition, in the drawings used in the following description, for convenience, in order to make the features of the present invention easy to understand, a part that is a main part may be enlarged in some cases, and a dimensional ratio or the like of each component is not always the same as an actual one.

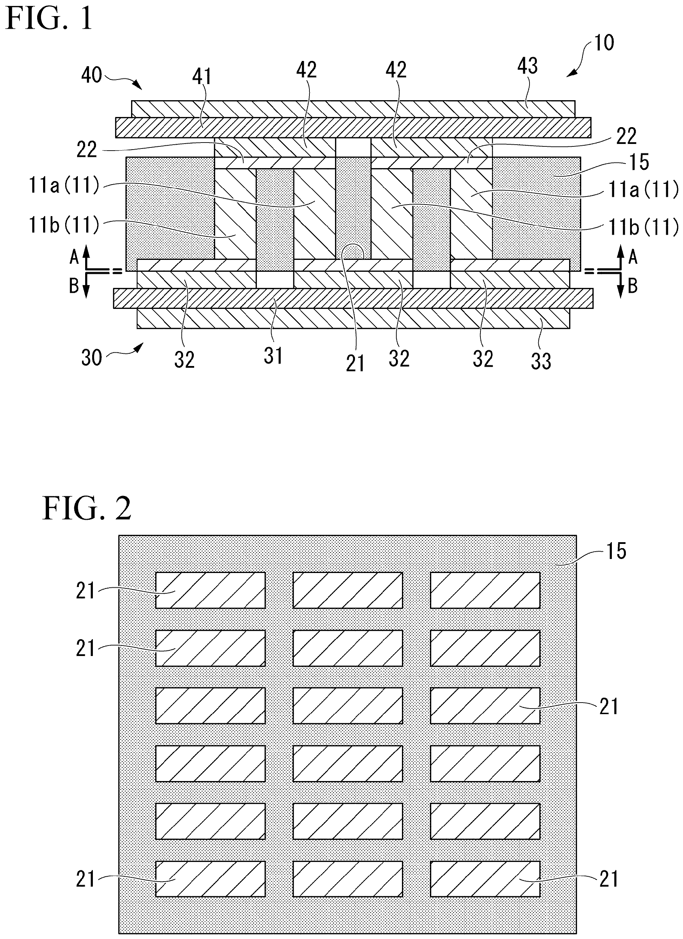

As shown in Fig. 1, a thermoelectric conversion module 10 according to the present embodiment includes a plurality of columnar thermoelectric conversion elements 11, and the plurality of columnar thermoelectric conversion elements 11 are electrically connected in series by first electrode parts 21 disposed to one end (lower side in Fig. 1) of the thermoelectric conversion elements 11 in a longitudinal direction thereof and second electrode parts 22 disposed to the other end (upper side in Fig. 1) of the thermoelectric conversion elements 11 in the longitudinal direction. Here, the first electrode parts 21 and the second electrode parts 22 are disposed in a pattern, for example, as shown in Fig. 2. The thermoelectric conversion element 11, the first electrode part 21, and the second electrode part 22 are each formed in a rectangular shape having the same size as each other in a plan view.

In the present embodiment, each of the first electrode part 21 and the second electrode part 22 is not fixed, and forms the thermoelectric conversion module having a so-called skeleton structure.

The first electrode part 21 and the second electrode part 22 are preferably formed of a metal having excellent conductivity and thermal conductivity. For example, pure metals such as copper, silver, gold, aluminum, iron, nickel, zinc, and tin, or alloys containing at least one thereof can be applied.

The thermoelectric conversion element 11 includes an n-type thermoelectric conversion element 11a and a p-type thermoelectric conversion element 11b, and these n-type thermoelectric conversion element 11a and p-type thermoelectric conversion element 11b are alternately arranged.

Metallized layers (not shown) are respectively formed on one end surface and the other end surface of the thermoelectric conversion element 11. As the metallized layer, for example, nickel, silver, cobalt, tungsten, molybdenum, or a nonwoven fabric made of fibers of such metals can be used. Furthermore, the outermost surface (bonding surface to the first electrode part 21 and the second electrode part 22) of the metallized layer is preferably formed of Au or Ag.

For example, the n-type thermoelectric conversion element 11a and the p-type thermoelectric conversion element 11b are formed of sintered materials of tellurium compounds, skutterudites, filled skutterudites, Heuslers, half-Heuslers, clathrates, silicides, oxides, or silicon-germanium.

As a material of the n-type thermoelectric conversion element 11a, for example, Bi₂Te₃, PbTe, La₃Te₄, CoSb₃, FeVAl, ZrNiSn, Ba₈Al₁₆Si₃₀, Mg₂Si, FeSi₂, SrTiO₃, CaMnO₃, ZnO, or SiGe is used.

As a material of the p-type thermoelectric conversion element 11b, for example, Bi₂Te₃, Sb₂Te₃, PbTe, TAGS (= Ag-Sb-Ge-Te), Zn₄Sb₃, CoSb₃, CeFe₄Sb₁₂, Yb₁₄MnSb₁₁, FeVAl, MnSi_{1.73}, FeSi₂, NaxCoO₂ Ca₃Co₄O₇, Bi₂Sr₂Co₂O₇, or SiGe is used.

There are a compound that can take both n-type and p-type by a dopant, and a compound that has only one of n-type and p-type properties.

In the present embodiment, the thermoelectric conversion elements 11 are sealed by a sealing layer 15 formed of an insulating inorganic material, and as shown in Fig. 1, one surfaces of the first electrode part 21 and the second electrode part 22 are configured to be exposed from the sealing layer 15.

The sealing layer 15 may seal the thermoelectric conversion element 11, the first electrode part 21 excluding the surface (lower side in Fig. 1) of the first electrode part 21 opposite to the surface facing the thermoelectric conversion element 11, and the second electrode part 22 excluding the surface (upper side in Fig. 1) of the second electrode part 22 opposite to the surface facing the thermoelectric conversion element 11.

As shown in Fig. 2, on one surface (lower side of Fig. 1) of the sealing layer 15, the surface of the first electrode part 21 opposite to the surface facing the thermoelectric conversion element 11 is exposed. Similarly, on the other surface (upper side of Fig. 1) of the sealing layer 15, the surface of the second electrode part 22 opposite to the surface facing the thermoelectric conversion element 11 is exposed.

The sealing layer 15 may be formed at a height (thickness) substantially equal to the total height of the thermoelectric conversion element 11, the first electrode part 21, and the second electrode part 22.

The sealing layer 15 is formed in a rectangular shape in a plan view.

The inorganic material forming the sealing layer 15 has an electrical resistivity of 1 × 10⁶ Ω·m or more at a temperature of 25°C after curing (state of the sealing layer 15). The electrical resistivity at a temperature of 200°C is preferably 1 × 10⁶ Ω·m or more, and a material whose conductivity does not increase due to temperature rise is preferable.

In the present embodiment, the inorganic material forming the sealing layer 15 preferably has a thermal conductivity of 2 W/(m·K) or less at 25°C. The thermal conductivity of the inorganic material forming the sealing layer 15 is preferably as low as possible.

As the inorganic material forming the sealing layer 15, specifically, one or two or more selected from alumina, magnesia, zirconia, and silica can be used.

In the present embodiment, as shown in Fig. 1, on one end of the thermoelectric conversion element 11, a first insulating circuit board 30 including a first insulating layer 31, a first circuit layer 32 formed on one surface of the first insulating layer 31, and a first heat transfer layer 33 formed on the other surface of the first insulating layer 31 is disposed.

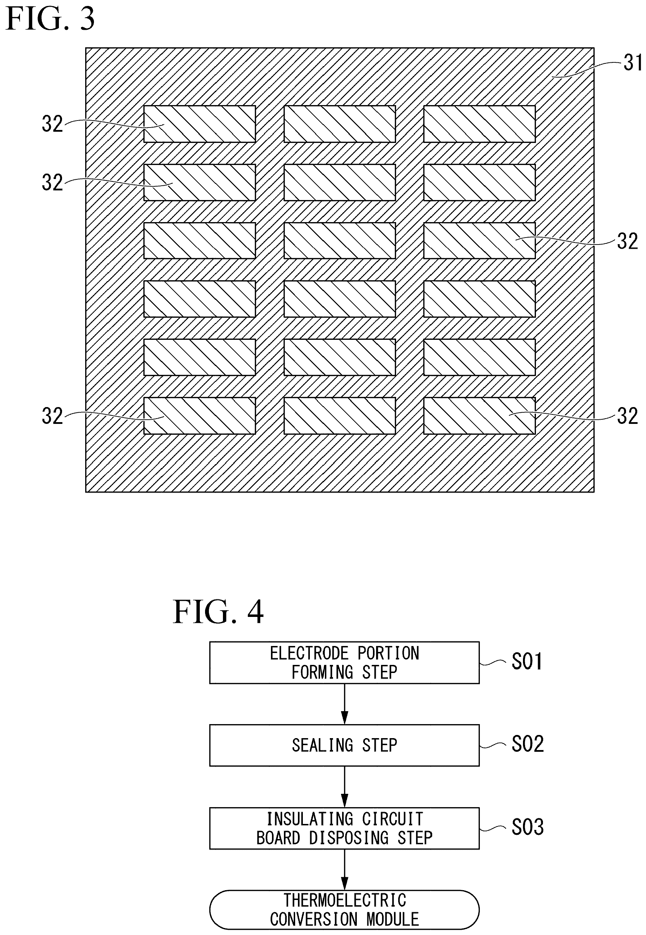

As shown in Fig. 3, the first circuit layer 32 is configured to have a pattern similar to that of the first electrode part 21, and is disposed so as to cover the first electrode part 21 exposed from the sealing layer 15. The first insulating layer 31, the first circuit layer 32, and the first heat transfer layer 33 are each formed in a rectangular shape in a plan view.

The contact area of the first circuit layer 32 is equal to or larger than the exposed area of the first electrode part 21, and is configured to reliably cover the exposed surface of the first electrode part 21.

The contact area of the first circuit layer 32 indicates the area of the entire surface of the first circuit layer 32 that faces the exposed surface of the first electrode part 21. The first circuit layer 32 may be formed so as to cover the sealing layer 15 formed around the first electrode part 21 in addition to the exposed surface of the first electrode part 21. In this case, the contact area of the first circuit layer 32 becomes (exposed area of the first electrode part 21) + (area of the sealing layer 15 in contact with the first circuit layer 32).

In the present embodiment, as shown in Fig. 1, on the other end of the thermoelectric conversion element 11, a second insulating circuit board 40 including a second insulating layer 41, a second circuit layer 42 formed on one surface of the second insulating layer 41, and a second heat transfer layer 43 formed on the other surface of the second insulating layer 41 is disposed.

The second circuit layer 42 is configured to have a pattern similar to that of the second electrode part 22, and is disposed so as to cover the second electrode part 22 exposed from the sealing layer 15. The second insulating layer 41, the second circuit layer 42, and the second heat transfer layer 43 are each formed in a rectangular shape in a plan view.

The contact area of the second circuit layer 42 is equal to or larger than the exposed area of the second electrode part 22, and is configured to reliably cover the exposed surface of the second electrode part 22.

The contact area of the second circuit layer 42 indicates the area of the entire surface the second circuit layer 42 that faces the exposed surface of the second electrode part 22. The second circuit layer 42 may be formed so as to cover the sealing layer 15 formed around the second electrode part 22 in addition to the exposed surface of the second electrode part 22. In this case, the contact area of the second circuit layer 42 becomes (exposed area of the second electrode part 22) + (area of the sealing layer 15 in contact with the second circuit layer 42).

The first insulating layer 31 and the second insulating layer 41 are preferably formed of a ceramic having excellent insulating properties. For example, aluminum nitride, alumina, or silicon nitride can be applied.

The thickness of the first insulating layer 31 and the second insulating layer 41 is preferably in a range of, for example, 0.1 mm or more and 2 mm or less.

The first circuit layer 32 and the second circuit layer 42 described above are formed of a metal having excellent thermal conductivity, for example, aluminum or an aluminum alloy, copper or a copper alloy, or iron or an iron alloy. In the present embodiment, the first circuit layer 32 and the second circuit layer 42 are formed of relatively soft aluminum having excellent thermal conductivity and a light weight (for example, 4N aluminum having a purity of 99.99 mass% or more).

The thickness of the first circuit layer 32 and the second circuit layer 42 is preferably in a range of, for example, 0.05 mm or more and 2 mm or less.

Similar to the first circuit layer 32 and the second circuit layer 42, the first heat transfer layer 33 and the second heat transfer layer 43 are formed of a metal having excellent thermal conductivity, for example, aluminum or an aluminum alloy, copper or a copper alloy, or iron or an iron alloy. In the present embodiment, the first heat transfer layer 33 and the second heat transfer layer 43 are formed of aluminum (for example, 4N aluminum having a purity of 99.99 mass% or more).

The thickness of the first heat transfer layer 33 and the second heat transfer layer 43 is preferably in a range of, for example, 0.05 mm or more and 2 mm or less.

In the first insulating circuit board 30, the first circuit layer 32, the first insulating layer 31, and the first heat transfer layer 33 are bonded and integrated, and in the second insulating circuit board 40, the second circuit layer. The 42, the second insulating layer 41, and the second heat transfer layer 43 are bonded and integrated.

A bonding method is not particularly limited, and it is preferable to appropriately select and adopt an existing bonding method such as brazing.

In the present embodiment, a pair of output terminals (not shown) are connected onto the surface of the first electrode part 21 opposite to the exposed surface. In the thermoelectric conversion module 10 of the present embodiment, the plurality of thermoelectric conversion elements 11 are connected in series between the pair of output terminals. The pair of output terminals may be covered with the sealing layer 15 as long as the output terminals are electrically connected to the first electrode part 21. As the material of the pair of output terminals, the same material as those exemplified in the first electrode part 21 described above can be used.

Of the pair of output terminals, one output terminal may be electrically connected to the first electrode part 21 located on the rightmost side and further on the lowermost side among the first electrode parts 21 shown in Fig. 2. One output terminal is formed in a rectangular or circular shape in a plan view.

Of the pair of output terminals, the other output terminal may be electrically connected to the first electrode part 21 located on the rightmost side and further on the uppermost side among the first electrode parts 21 shown in Fig. 2. The other output terminal is formed in a rectangular or circular shape in a plan view.

Next, a method for producing the thermoelectric conversion module 10, which is the present embodiment described above, will be described with reference to Fig. 4.

### (Electrode Part Forming Step S01)

The plurality of thermoelectric conversion elements 11 are disposed, the first electrode part 21 is formed on one end of the thermoelectric conversion elements 11, and the second electrode part 22 is formed on the other end of the thermoelectric conversion elements 11. At this time, the first electrode part 21 and the second electrode part 22 are configured to have a predetermined pattern so that the plurality of thermoelectric conversion elements 11 are connected in series.

### (Sealing Step S02)

The plurality of thermoelectric conversion elements 11 on which the first electrode part 21 and the second electrode part 22 are formed are accommodated in a mold, and as a potting material in the mold, for example, a liquid containing a ceramic adhesive Thermeez 7030 (filler: silica) manufactured by Taiyo Wire Cloth Co., Ltd. and tap water that are well-mixed at 2:1 (weight ratio) is poured. Here, as the potting material, it is preferable to use a filler containing one or two or more selected from alumina, magnesia, zirconia, and silica.

Then, the potting material is semi-dried by being held at a temperature of 50°C or higher and 70°C or lower for 20 minutes or longer and 60 minutes or shorter.

In this state, the potting material is shaped so that the first electrode part 21 and the second electrode part 22 are exposed. In addition, potting may be performed after connecting the output terminals. In this case, it is preferable that the connection parts of the output terminals are subjected to potting.

Thereafter, the potting material is completely cured by being held at a temperature of 120°C or higher and 150°C or lower for 240 minutes or longer, thereby forming the sealing layer 15.

### (Insulating Circuit Board Disposing Step S03)

The first insulating circuit board 30 is disposed to one end of each of the thermoelectric conversion elements 11, the second insulating circuit board 40 is disposed to the other end of each of the thermoelectric conversion elements 11, and the thermoelectric conversion elements 11 are sandwiched between the first insulating circuit board 30 and the second insulating circuit board 40.

At this time, the first circuit layer 32 is disposed so as to cover the first electrode part 21 exposed from the sealing layer 15, and the second circuit layer 42 disposed so as to cover the second electrode part 22 exposed from the sealing layer 15.

By the above steps, the thermoelectric conversion module 10 according to the present embodiment is produced.

In the thermoelectric conversion module 10 of the present embodiment thus obtained, for example, the first insulating circuit board 30 side is used as a low temperature part, the second insulating circuit board 40 side is used as a high temperature part, conversion between thermal energy and electric energy is performed.

In the thermoelectric conversion module 10 of the present embodiment having the above configuration, since the thermoelectric conversion elements 11 are sealed by the sealing layer 15 formed of the insulating inorganic material, even in a case where the thermoelectric conversion module 10 is used in a high temperature region of 250°C or higher, the sealing layer 15 is not altered, and excellent weather resistance is achieved, so that the degradation of the thermoelectric conversion element 11 can be suppressed. In addition, since the thermoelectric conversion elements 11 are protected by the sealing layer 15 formed of the insulating inorganic material, the structure is simple, and a reduction in the size and weight of the thermoelectric conversion module 10 can be achieved.

Since one surfaces of the first electrode part 21 and the second electrode part 22 are exposed from the sealing layer 15, the electric energy generated in the thermoelectric conversion elements 11 can be efficiently extracted via the first electrode part 21 and the second electrode part 22.

In the present embodiment, in a case where the inorganic material forming the sealing layer 15 has a thermal conductivity of 2 W/(m·K) or less at 25°C, heat transfer via the sealing layer 15 can be suppressed, it is possible to sufficiently secure a temperature difference between one end and the other end of the thermoelectric conversion elements 11, and the thermoelectric conversion efficiency can be improved.

In the present embodiment, each of the first electrode part 21 and the second electrode part 22 is not fixed, and forms the thermoelectric conversion module having a so-called skeleton structure. In addition, the first insulating circuit board 30 including the first insulating layer 31 and the first circuit layer 32 formed on one surface of the first insulating layer 31 is disposed to one end of each of the thermoelectric conversion elements 11, and the first circuit layer 32 is disposed so as to cover the first electrode part 21 exposed from the sealing layer 15. Furthermore, the second insulating circuit board 40 including the second insulating layer 41 and the second circuit layer 42 formed on one surface of the second insulating layer 41 is disposed to the other end of each of the thermoelectric conversion elements 11, and the second circuit layer 42 is disposed so as to cover the second electrode part 22 exposed from the sealing layer 15. Therefore, the contact between the first electrode part 21 and the first circuit layer 32 and between the second electrode part 22 and the second circuit layer 42 is improved, and the insulating properties are secured by the first insulating layer 31 and the second insulating layer 41, so that it is possible to sufficiently improve the thermoelectric conversion efficiency. In addition, as described above, by disposing the first insulating circuit board 30 and the second insulating circuit board 40, the insulating properties and the heat transfer properties can be secured, and a reduction in the number of components can be achieved.

In the present embodiment, in a case where the contact area of the first circuit layer 32 is equal to or larger than the exposed area of the first electrode part 21, and the contact area of the second circuit layer 42 is equal to or larger than the exposed area of the second electrode part 22, the first electrode part 21 and the second electrode part 22 exposed from the sealing layer 15 can be reliably covered by the first circuit layer 32 and the second circuit layer, infiltration of moisture or the like from the interfaces between the first electrode part 21 and the second electrode part 22 and the sealing layer 15 can be suppressed, and it is possible to more reliably suppress the degradation of the thermoelectric conversion elements 11.

While the embodiment of the present invention has been described above, the present invention is not limited thereto and can be appropriately modified without departing from the technical idea of the invention.

In the present embodiment, it is described that each of the first electrode part 21 and the second electrode part 22 is not fixed, and forms the thermoelectric conversion module having a so-called skeleton structure, and the first insulating circuit board 30 and the second insulating circuit board 40 are respectively disposed to the first electrode part 21 and the second electrode part 22, the structure is not limited thereto.

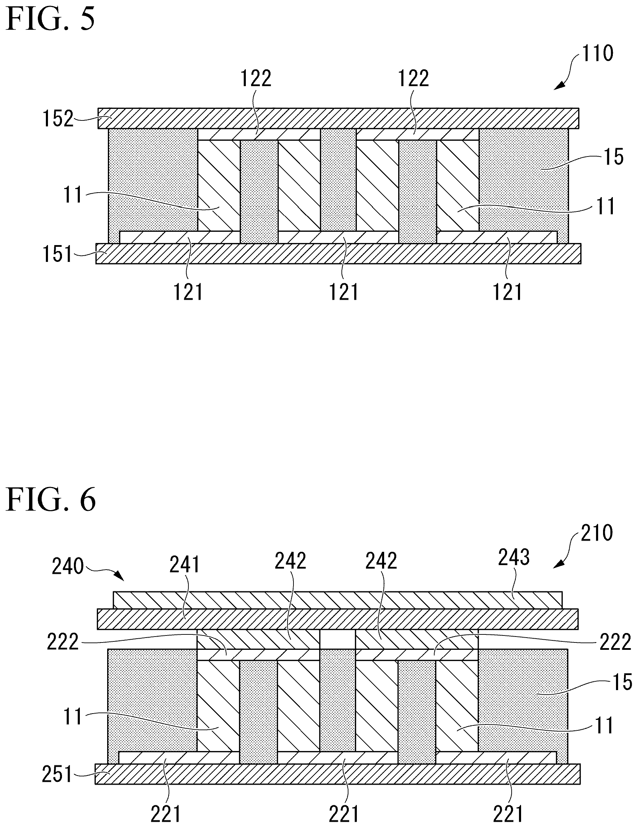

For example, like a thermoelectric conversion module 110 shown in Fig. 5, a rigid structure in which a first electrode part 121 and a second electrode part 122 are respectively fixed to ceramic substrates 151 and 152 may be adopted as long as the thermoelectric conversion elements 11 are sealed with the sealing layer 15 formed of the insulating inorganic material. Even in this case, the weather resistance is improved and the degradation of the thermoelectric conversion elements 11 can be suppressed. The ceramic substrates 151 and 152 are preferably formed of a ceramic having excellent insulating properties. For example, aluminum nitride, alumina, or silicon nitride can be applied.

Like a thermoelectric conversion module 210 shown in Fig. 6, a half skeleton structure in which a first electrode part 221 is fixed to a ceramic substrate 251 and a second electrode part 222 is not fixed may be adopted as long as the thermoelectric conversion elements 11 are sealed with the sealing layer 15 formed of the insulating inorganic material. Even in this case, the weather resistance is improved and the degradation of the thermoelectric conversion elements 11 can be suppressed. In the case of the half skeleton structure, it is preferable to dispose a second insulating circuit board 240 on the second electrode part 222 which is not fixed. In addition, it is preferable to use the second electrode part 222 as a high temperature part.

### INDUSTRIAL APPLICABILITY

According to the present invention, it is possible to provide a thermoelectric conversion module in which excellent weather resistance is achieved, the degradation of thermoelectric conversion elements in a use environment is suppressed, and favorable and stable use is possible even at a high temperature, with a relatively simple structure.

### [Reference Signs List]

10: Thermoelectric conversion module
11: Thermoelectric conversion element
11a: n-type thermoelectric conversion element
11b: p-type thermoelectric conversion element
15: Sealing layer
21: First electrode part
22: Second electrode part
30: First insulating circuit board
31: First insulating layer
32: First circuit layer
40: Second insulating circuit board
41: Second insulating layer
42: Second circuit layer

## Claims

1. A thermoelectric conversion module comprising:
a plurality of thermoelectric conversion elements;
a first electrode part disposed to one end of each of the thermoelectric conversion elements; and
a second electrode part disposed to the other end of each of the thermoelectric conversion elements,
wherein the plurality of thermoelectric conversion elements are electrically connected to each other via the first electrode part and the second electrode part,
the thermoelectric conversion elements are sealed by a sealing layer formed of an insulating inorganic material, and
one surfaces of the first electrode part and the second electrode part are exposed from the sealing layer.

2. The thermoelectric conversion module according to Claim 1,
wherein the inorganic material forming the sealing layer has a thermal conductivity of 2 W/(m·K) or less at 25°C.

3. The thermoelectric conversion module according to Claim 1 or 2,
wherein a first insulating circuit board including a first insulating layer and a first circuit layer formed on one surface of the first insulating layer is disposed to the one end of the thermoelectric conversion elements, and
the first circuit layer is disposed so as to cover the first electrode part exposed from the sealing layer.

4. The thermoelectric conversion module according to Claim 3,
wherein a contact area of the first circuit layer is equal to or larger than an exposed area of the first electrode part.

5. The thermoelectric conversion module according to any one of Claims 1 to 4,
wherein a second insulating circuit board including a second insulating layer and a second circuit layer formed on one surface of the second insulating layer is disposed to the other end of each of the thermoelectric conversion elements, and
the second circuit layer is disposed so as to cover the second electrode part exposed from the sealing layer.

6. The thermoelectric conversion module according to Claim 5,
wherein a contact area of the second circuit layer is equal to or larger than an exposed area of the second electrode part.
